# EUROPEAN PATENT APPLICATION

(11) **EP 4 782 424 A1**
(43) Date of publication of application: **29.07.2026**
(21) Application number: 24868011.8
(22) Date of filing: 21.08.2024
(51) Int. Cl.: C04B 35/587, H01L 23/13, H05K 1/03

(54) **SILICON NITRIDE SINTERED BODY, SILICON NITRIDE SUBSTRATE, SILICON NITRIDE CIRCUIT BOARD, AND SEMICONDUCTOR DEVICE**

(30) Priority: 19.09.2023 JP 2023151622
(71) Applicant: Niterra Materials Co., Ltd., Yokohama-shi, Kanagawa 235-0032 (JP)
(72) Inventor: YAMAGATA, Yoshihito, Yokohama-shi, Kanagawa 235-0032 (JP); AOKI, Katsuyuki, Yokohama-shi, Kanagawa 235-0032 (JP); TAKEUCHI, Yuta, Yokohama-shi, Kanagawa 235-0032 (JP)
(74) Representative: Hoffmann Eitle
(86) International application number: PCT/JP2024/029709
(87) International publication number: WO 2025/062931

(57) **Abstract**

A silicon nitride substrate attaining improved long-term reliability is provided. According to one embodiment, in a case where a DC electric field of 5 kV/mm is applied to a silicon nitride sintered body at 25°C, a ratio Q25(600)/Q25(5) of an accumulated charge amount 600 seconds after a start of application to an accumulated charge amount 5 seconds after the start of the application is not less than 1.0 and not more than 3.0. A thermal conductivity of the silicon nitride sintered body is 65 W/m·K or more.

## Description

### [Technical Field]

Embodiments described below relate generally to a silicon nitride sintered body, a silicon nitride substrate, a silicon nitride circuit board, and a semiconductor device.

### [Background Art]

A silicon nitride substrate composed of a silicon nitride sintered body has a high thermal conductivity and a high strength. For example, Japanese Patent No. 6293772 (Patent Literature 1) discloses a silicon nitride substrate having a thermal conductivity of 50 W/m·K or more and a three-point bending strength of 600 MPa or more. In Patent Literature 1, the distribution of the grain boundary phase in the thickness direction of the substrate is controlled. This improves thermal conductivity, strength, and insulation properties. Japanese Patent No. 7170629 (Patent Literature 2) also discloses a silicon nitride substrate having a thermal conductivity of 50 W/m·K or more and a three-point bending strength of 600 MPa or more. In Patent Literature 2, the grain boundary phase contains a plurality of glass compound phases having different compositions. This improves thermal conductivity, strength, and insulation properties.

In Patent Literature 1 and Patent Literature 2, the insulation properties are evaluated by using the dielectric strength. In a dielectric strength test, electrodes are bonded to both sides of the silicon nitride substrate to measure a voltage at which dielectric breakdown occurs. The dielectric strength test is a type of breakdown test, and a voltage is kept applied until dielectric breakdown occurs.

### [Prior Art Documents]

### [Patent Literature]

[Patent Literature 1] Japanese Patent No. 6293772
[Patent Literature 2] Japanese Patent No. 7170629

### [Summary of Invention]

### [Problem to be Solved by the Invention]

The silicon nitride substrates of Patent Literature 1 and Patent Literature 2 have a dielectric strength of 15 kV/mm or more. However, silicon nitride substrates having a dielectric strength of 15 kV/mm or more do not have sufficient long-term reliability in some cases.

In dielectric strength tests, an AC electric field is often used to evaluate characteristics. Meanwhile, a DC electric field may be applied instead of an AC electric field to, for example, a power module in which a semiconductor element is mounted. Alternatively, a DC electric field may be converted to an AC electric field, and the AC electric field and the DC electric field may be alternately applied to the power module. The dielectric strength of a silicon nitride substrate is around 15 kV/mm. This dielectric strength is considerably larger than a dielectric strength required at the driving voltage of, for example, a power module in which a semiconductor element is mounted. However, even in a case where a silicon nitride substrate having a sufficient dielectric strength is used, long-term reliability may be insufficient. This shows that the dielectric strength is not necessarily an appropriate index to ensure long-term reliability under practical conditions.

Embodiments described herein are intended to address such problems and to provide a silicon nitride substrate attaining improved long-term reliability under practical conditions of a semiconductor element.

### [Means for Solving the Problem]

According to one embodiment, in a case where a DC electric field of 5 kV/mm is applied to a silicon nitride sintered body at 25°C, a ratio Q25(600)/Q25(5) of an accumulated charge amount 600 seconds after a start of application to an accumulated charge amount 5 seconds after the start of the application is not less than 1.0 and not more than 3.0. A thermal conductivity of the silicon nitride sintered body is 65 W/m·K or more.

### [Brief Description of Drawings]

[FIG. 1] FIG. 1 is a perspective view showing an example of a silicon nitride substrate according to an embodiment.
[FIG. 2] FIG. 2 is a diagram showing example results of measuring the accumulated charge amount of a silicon nitride substrate according to Example 1.
[FIG. 3] FIG. 3 is a diagram showing example results of measuring the accumulated charge amount of a silicon nitride substrate according to Comparative Example 1.
[FIG. 4] FIG. 4 is a side view showing an example of a silicon nitride circuit board according to the embodiment.
[FIG. 5] FIG. 5 is a diagram showing an example of a semiconductor device according to the embodiment.

### [Description of Embodiments]

According to one embodiment, in a case where a DC electric field of 5 kV/mm is applied to a silicon nitride sintered body at 25°C, a ratio Q25(600)/Q25(5) of an accumulated charge amount 600 seconds after a start of application to an accumulated charge amount 5 seconds after the start of the application is not less than 1.0 and not more than 3.0. A thermal conductivity of the silicon nitride sintered body is 65 W/m·K or more.

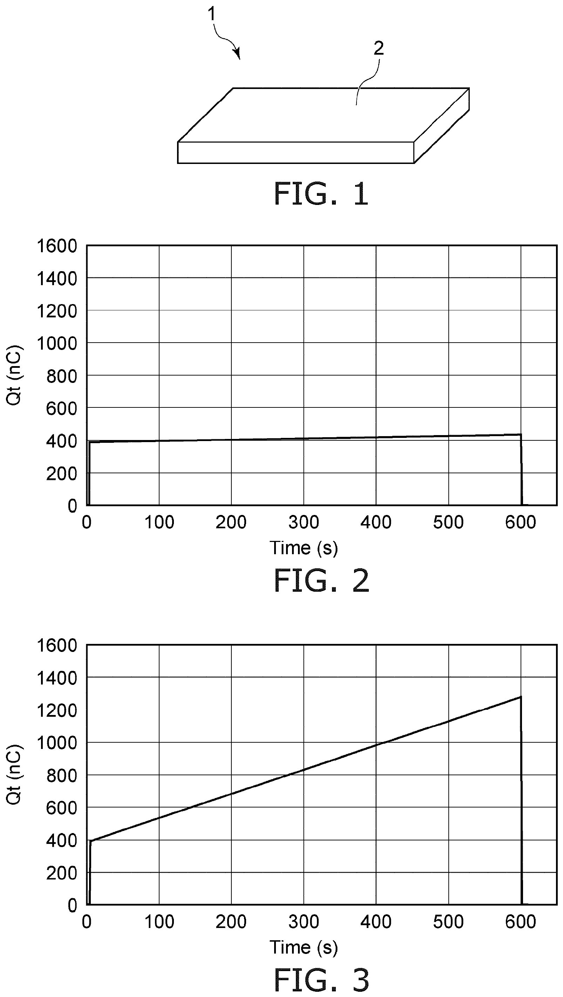

FIG. 1 is a perspective view showing an example of a silicon nitride substrate according to an embodiment. In FIG. 1, reference numeral 1 indicates a silicon nitride substrate, and reference numeral 2 indicates a surface portion. FIG. 1 shows a silicon nitride sintered body in the form of a substrate. That is, the silicon nitride sintered body in the form of a substrate is a silicon nitride substrate. In the example shown in FIG. 1, the shape of the surface portion 2 when viewed from above is a rectangular shape. The shape of the surface portion 2 is not limited to this example, and may be, for example, a square shape, a polygonal shape other than a quadrangular shape, a circle shape, an L-shape, or a U-shape.

The silicon nitride sintered body according to the embodiment is characterized in that an accumulated charge amount ratio Q25(600)/Q25(5) is not less than 1.0 and not more than 3.0. "Q25(5)" is, in a case where a DC electric field of 5 kV/mm is applied to the silicon nitride sintered body at 25°C, an accumulated charge amount 5 seconds after the start of application of the electric field. "Q25(600)" is, in the case where a DC electric field of 5 kV/mm is applied to the silicon nitride sintered body at 25°C, an accumulated charge amount 600 seconds after the start of the application of the electric field.

The "accumulated charge amount" is the amount of charge accumulated in the silicon nitride sintered body when a certain voltage is applied. The voltage is set so that the DC electric field becomes 5 kV/mm, and varies in accordance with the thickness of the substrate. The state in which Q25(600)/Q25(5) is not less than 1.0 and not more than 3.0 indicates that the accumulated charge amount after 600 seconds is within the range from 1.0 time to 3.0 times the accumulated charge amount after 5 seconds. This shows that the amount of charge accumulated as time passes is small. As Q25(600)/Q25(5) is closer to 1.0, the amount of charge accumulated as time passes is smaller.

A large accumulated charge amount ratio indicates that charge is accumulated in a short time, and the accumulated charge is less likely to be released in a short time. If charge remains in the silicon nitride sintered body, it causes dielectric breakdown. The operating frequency of semiconductor elements has been increased in recent years. When a semiconductor element repeats on and off at a predetermined frequency, the accumulated charge is not sufficiently released, and the following charge is continuously accumulated. As a result, the accumulated charge causes dielectric breakdown. Therefore, a small accumulated charge amount ratio indicates that the accumulated charge is released in a short time and that long-term reliability is high. Here, "long-term reliability" means that the possibility of dielectric breakdown occurring in the silicon nitride sintered body is sufficiently low even in a case where the semiconductor device is used for a long period of one year or more.

The DC electric field of 5 kV/mm is set by assuming the driving voltage of a typical semiconductor element. The lower limit of Q25(600)/Q25(5) is 1.0. Since the accumulated charge amount is the amount of charge accumulated over time, Q25(600)/Q25(5) does not become less than 1.0.

For example, the driving voltage of the power card of electric vehicles (including hybrid vehicles) is designed to be about 1 kV. The power card is a power module for, for example, controlling the power of the motor of the electric vehicle, and is a card-type module on which a plurality of semiconductor elements are mounted.

In a case where the thickness of the silicon nitride substrate is 0.32 mm, the applied voltage for making the DC electric field be 5 kV/mm is 1.6 kV (= 5 kV/mm × 0.32 mm). In a case where the thickness of the silicon nitride substrate is 0.25 mm, the applied voltage for making the DC electric field be 5 kV/mm is 1.25 kV (= 5 kV/mm × 0.25 mm).

The measurement time is set to 5 seconds and 600 seconds. Immediately after the start of application of the DC electric field, charge is accumulated in the silicon nitride sintered body. Therefore, the accumulated charge amount steeply increases. In a case where the DC electric field is set to 5 kV/mm, the accumulated charge amount saturates in about 1 to 2 seconds. Therefore, after the elapse of 5 seconds from the start of the application of the electric field, the increase in the accumulated charge amount is sufficiently slow compared with that immediately after the start of the application. The measurement time of 600 seconds is set as a sufficiently long time relative to 5 seconds. The rate of increase in the accumulated charge amount during the period from 5 seconds to 600 seconds is substantially the same as the rate of increase in the accumulated charge amount after 600 seconds. That is, the accumulated charge amount increases substantially linearly after the saturation immediately after the start of the application of the electric field. Setting the measurement time to 600 seconds provides data sufficient to estimate the long-term reliability.

The DC electric field of 5 kV/mm is a condition appropriate to practical criteria. Q25(600)/Q25(5) for the DC electric field of 5 kV/mm at 25°C is a measurement of the rate of increase of the amount of charge stored in the silicon nitride substrate at the driving voltage of a typical semiconductor element. Q25(5) is the accumulated charge amount in the initial stage. Q25(5) is preferably 500 nC (nano Coulomb) or less. 500 nC is 0.5 µC (micro Coulomb). The lower limit of Q25(5) is not specifically limited, but is preferably 300 nC or more.

The value of the accumulated charge amount is affected by the size of a measurement electrode described below. That is, the accumulated charge amount is proportional to the contact area between the silicon nitride substrate and the measurement electrode. The specific charge amounts described above are values when a measurement electrode of 40 mmϕ is used. In a case of a measurement electrode of 30 mmϕ, Q25(5) is preferably 300 nC or less.

The accumulated charge amount is measured by the following method. As the measuring device, the Q(t) meter (model No. AD-9832A) from A&D Company, Limited or a device having equivalent performance is used. In the measurement, a measurement electrode of 40 mmϕ is used. A measurement electrode of 30 mmϕ may be used so as not to cause creeping leakage of the silicon nitride substrate. Creeping leakage can be sufficiently suppressed if the creeping distance of the silicon nitride substrate is 1 mm or more. In a case where the use of a measurement electrode of 40 mmϕ results in the creeping distance of less than 1 mm, a measuring electrode of 30 mmϕ may be used. The accumulated charge amount is also affected by the size of the measurement electrode. Therefore, if a measurement electrode of 40 mmϕ can be used, a measuring electrode of 40 mmϕ is used in measurement of the accumulated charge amount.

First, measurement electrodes are brought into contact with the front face and the back face of the silicon nitride substrate respectively. A voltage corresponding to the thickness of the silicon nitride substrate is applied so that the applied electric field becomes 5 kV/mm. In a case where the measuring temperature is room temperature, the temperature in the measuring chamber is set to 25°C, and the silicon nitride substrate is held in the chamber for 5 minutes or more. After the temperature of the silicon nitride substrate becomes substantially equal to the room temperature, the accumulated charge amount is measured. In a case where the measuring temperature is 100°C, the mounting table (for example, a hot plate) of the measuring instrument is set to 100°C, and the silicon nitride substrate is held on the mounting table for 5 minutes or more. After the temperature of the silicon nitride substrate becomes substantially 100°C, the accumulated charge amount is measured. In a case where the measuring temperature is 200°C, the mounting table (for example, a hot plate) of the measuring instrument is set to 200°C, and the silicon nitride substrate is held on the mounting table for 5 minutes or more. After the temperature of the silicon nitride substrate becomes substantially 200°C, the accumulated charge amount is measured. In the measurement, the electric field of 5 kV/mm is applied. In order to suppress a change in the characteristics of the silicon nitride substrate, the upper limit of the holding time is preferably 10 minutes or less.

The accumulated charge amount is measured every 0.5 seconds after the start of the application of the electric field to obtain a graph showing changes in the accumulated charge amount with respect to time. From the obtained graph, the accumulated charge amount Q(5) 5 seconds after the start of the application of the voltage and the accumulated charge amount Q(600) 600 seconds after the start of the application of the voltage are read. The accumulated charge amount Q(600) is divided by the accumulated charge amount Q(5) to thereby obtain the ratio Q(600)/Q(5) of the accumulated charge amount.

FIG. 2 shows example results of measuring the accumulated charge amount of silicon nitride according to Example 1. FIG. 3 shows example results of measuring the accumulated charge amount of silicon nitride according to Comparative Example 1. FIG. 2 and FIG. 3 show results of measuring the accumulated charge amount at 25°C. In FIG. 2 and FIG. 3, the horizontal axis represents time (seconds), and the vertical axis represents the accumulated charge amount (Q25). From the measurement results shown in FIG. 2 and FIG. 3, the accumulated charge amount Q25(5) after 5 seconds and the accumulated charge amount Q25(600) after 600 seconds are read.

The content of fluorine in the silicon nitride sintered body is preferably not less than 0 wtppm and not more than 1000 wtppm. The content of iron is preferably not less than 0 wtppm and not more than 500 wtppm. The content of sodium is preferably not less than 0 wtppm and not more than 500 wtppm.

Fluorine, iron, and sodium are likely to be mixed into the silicon nitride sintered body as impurities. These elements are mixed into a silicon nitride powder or a sintering aid powder, or are mixed during the manufacturing process. Fluorine may exist as a fluorine compound in the silicon nitride sintered body. Iron may exist as an iron compound (including an iron alloy). Sodium may exist as a sodium compound (including a sodium compound). Fluorine, iron, and sodium are likely to become charge carriers in a sintered body under a DC electric field. If a large amount of these elements are mixed into the silicon nitride sintered body, Q25(600)/Q25(5) may exceed 3.0.

Therefore, the content of fluorine is preferably within the range of not less than 0 wtppm and not more than 1000 wtppm, and more preferably within the range of not less than 0 wtppm and not more than 500 wtppm. The content of iron is preferably within the range of not less than 0 wtppm and not more than 500 wtppm, and more preferably within the range of not less than 0 wtppm and not more than 300 wtppm. The content of sodium is preferably within the range of not less than 0 wtppm and not more than 200 wtppm.

Since fluorine, iron, and sodium are impurities, their contents are preferably 0 wtppm (below the detection limit). Meanwhile, the contents of 0 wtppm can lead to an increase in the manufacturing cost. Therefore, the content of fluorine may be 10 wtppm or more. The content of iron may be 10 wtppm or more. The content of sodium may be 10 wtppm or more. In other words, according to the embodiment of the invention, even if these impurities are contained, the characteristics of the silicon nitride sintered body can be improved.

The content of fluorine in the silicon nitride sintered body is measured by using thermal hydrolysis separation. By the thermal hydrolysis separation, fluorine in the silicon nitride sintered body is recovered in a solution. The concentration of the recovered fluorine is analyzed by ion chromatography. In the ion chromatography, ICS-2100 from Thermo Fisher Scientific Inc. or a device having equivalent performance is used.

The content of iron and the content of sodium are measured by using high-frequency inductively coupled plasma (ICP) emission spectrometry. The silicon nitride sintered body is converted into a solution by pressure acid decomposition . The amount of iron and the amount of sodium included in the solution is measured by ICP emission spectrometry. In the ICP emission spectrometry, SPS-3520UVDD from Hitachi High-Tech Science Corporation or a device having equivalent performance is used. In the ion chromatography and the ICP emission spectrometry, simple fluorine, simple iron, and simple sodium are detected, and the content of each of fluorine, iron, and sodium is measured. Any content below the detection limit is determined to be 0 wtppm.

In the surface portion 2 of the silicon nitride sintered body 1, a maximum height Sz is preferably 60 µm or less. The maximum height Sz is the distance between the highest point of the surface (the highest projection) and the lowest point of the surface (the lowest indentation) in the thickness direction. The maximum height Sz is defined in ISO 25178. When the maximum height Sz is controlled, an electric field concentration on the surface portion 2 can be suppressed. Local irregularities may cause an electric field concentration.

A metal plate is bonded to the surface portion 2 of the silicon nitride substrate 1 to obtain a silicon nitride circuit board. As described below, the metal plate may be bonded to the surface portion 2 with a bonding layer interposed therebetween. If a local electric field concentration occurs on the surface portion 2, charge may enter the silicon nitride substrate 1 through the metal plate or the bonding layer. The maximum height Sz exceeding 60 µm may cause the electric field concentration. When the maximum height Sz is controlled to 60 µm or less, the local electric field concentration can be suppressed, and entry of charge through the metal plate or the bonding layer can be suppressed.

The maximum height Sz that is smaller is preferable. The lower limit of the maximum height Sz is not specifically limited, but is preferably 20 µm or more. To make the maximum height Sz be less than 20 µm, the load of a polishing process increases, and this may cause an increase in costs. Therefore, the maximum height Sz is preferably within the range of not less than 20 µm and not more than 60 µm, and more preferably within the range of not less than 25 µm and not more than 55 µm.

The maximum peak height Sp of the surface portion 2 is preferably not less than 10 µm and not more than 30 µm. The maximum valley depth Sv of the surface portion 2 is preferably not less than 10 µm and not more than 30 µm. It is also preferable that 0.5 ≤ maximum peak height Sp/maximum valley depth Sv ≤ 2 be satisfied. As the projection from the surface is higher, the maximum peak height Sp become a larger value. As the indentation from the surface is deeper, the maximum valley depth Sv become a larger value. The maximum height Sz is expressed by the sum of the maximum peak height Sp and the maximum valley depth Sv. A large difference between the maximum peak height Sp and the maximum valley depth Sv may cause a local electric field concentration.

The maximum height Sz, the maximum peak height Sp, and the maximum valley depth Sv are measured by a method conforming to ISO 25178. As the measuring device, the one-shot 3D form measuring device VR-5000 series from KEYENCE or a device having equivalent performance is used. The measurement area is set to 9 mm in length and 12 mm in width. A plurality of measurement areas are set in accordance with the size of the silicon nitride sintered body. The plurality of measurement areas are set so as not to overlap each other. Preferably, ten measurement areas that do not overlap each other are set. In each measurement area, the maximum height Sz, the maximum peak height Sp, and the maximum valley depth Sv are measured, and the average value of the maximum heights Sz, that of the maximum peak heights Sp, and that of the maximum valley depths Sv in the plurality of measurement areas are calculated. The average value of the maximum heights Sz in the ten measurement areas is assumed to be the maximum height Sz of the surface of the silicon nitride sintered body. The average value of the maximum peak heights Sp in the ten measurement areas is assumed to be the maximum peak height Sp of the surface of the silicon nitride sintered body. The average value of the maximum valley depths Sv in the ten measurement areas is assumed to be the maximum valley depth Sv of the surface of the silicon nitride sintered body. In a case where the area of the surface is small and ten measurement areas that do not overlap each other are unable to be set, measurement areas are set as many as possible. In this case, the maximum height Sz, the maximum peak height Sp, and the maximum valley depth Sv are measured in each of the set measurement areas. The average value of the maximum heights Sz, that of the maximum peak heights Sp, and that of the maximum valley depths Sv in the plurality of measurement areas are used as the maximum height Sz, the maximum peak height Sp, and the maximum valley depth Sv of the surface of the silicon nitride sintered body respectively. In a case where only one measurement area can be set on the surface, the maximum height Sz, the maximum peak height Sp, and the maximum valley depth Sv are measured in the one measurement area, and the measurement results are used as the maximum height Sz, the maximum peak height Sp, and the maximum valley depth Sv of the surface of the silicon nitride sintered body. When the surface shape of the silicon nitride sintered body is measured, it is preferable that one or more types selected from among the maximum height Sz, the maximum peak height Sp, and the maximum valley depth Sv satisfy the above-described conditions.

When the amount of impurities and the surface roughness of the silicon nitride sintered body are controlled, the accumulated charge amount ratio Q25(600)/Q25(5) at room temperature (25°C) can be controlled. Further, the temperature dependence of the accumulated charge amount ratio can be made smaller. In a case where a DC electric field of 5 kV/mm is applied at 100°C, an accumulated charge amount 5 seconds after the start of the application of the electric field is denoted as Q100(5). In the case where a DC electric field of 5 kV/mm is applied at 100°C, an accumulated charge amount 600 seconds after the start of the application of the electric field is denoted as Q100(600). The accumulated charge amount ratio Q100(600)/Q100(5) is preferably within the range of not less than 1.0 and not more than 5.0. The state in which the accumulated charge amount ratio Q100(600)/Q100(5) is within the range of not less than 1.0 and not more than 5.0 indicates that the rate of increase in the accumulated charge amount over time is small even in a case where a DC electric field is applied in a high-temperature environment. The state in which the accumulated charge amount ratio Q25(600)/Q25(5) is 3.0 or less and the accumulated charge amount ratio Q100(600)/Q100(5) is 5.0 or less indicates that changes in the characteristics of the accumulated charge amount ratio are small even in a case where the temperature rises.

In a case where a DC electric field of 5 kV/mm is applied at 200°C, an accumulated charge amount 5 seconds after the start of the application of the electric field is denoted as Q200(5). In the case where a DC electric field of 5 kV/mm is applied at 200°C, an accumulated charge amount 600 seconds after the start of the application of the electric field is denoted as Q200(600). The accumulated charge amount ratio Q200(600)/Q200(5) is preferably within the range of not less than 1.0 and not more than 10.0.

Temperatures of 100°C and 200°C are temperatures assuming heat generation during operation of the semiconductor element. With the recent improvement in the performance of semiconductor elements, the operating temperature and the guaranteed temperature have been increased. As the temperature increases, the carrier mobility increases, and the accumulated charge amount increases accordingly. When the accumulated charge amount ratios at 100°C and 200°C are controlled, even in a case where the semiconductor element is operated at a high temperature, deterioration of the insulation properties of the silicon nitride sintered body can be suppressed.

The accumulated charge amount ratio Q100(600)/Q100(5) is preferably within the range of not less than 1.0 and not more than 5.0, and more preferably within the range of not less than 1.0 and not more than 3.0. The accumulated charge amount Q100(5) is preferably 500 nC (nano Coulomb) or less. The accumulated charge amount ratio Q200(600)/Q200(5) is preferably within the range of not less than 1.0 and not more than 10.0, and more preferably within the range of not less than 1.0 and not more than 6.0. The accumulated charge amount Q200(5) is preferably 500 nC (nano Coulomb) or less.

The silicon nitride sintered body preferably includes a grain boundary phase. As described below, the main component of the grain boundary phase is a sintering aid. The grain boundary phase preferably contains one or more types selected from the group consisting of a rare earth element, magnesium, titanium, zirconium, hafnium, molybdenum, and tungsten. The content of the grain boundary phase in the silicon nitride sintered body is preferably not less than 1 mass% and not more than 20 mass%. The ratio of the grain boundary phase may be calculated by subtracting the mass of silicon nitride from the mass of the silicon nitride sintered body.

The grain boundary phase preferably contains a crystal compound. The crystal compound preferably contains one or more types selected from the group consisting of a rare earth element, magnesium, titanium, zirconium, hafnium, molybdenum, and tungsten. The presence of the crystal compound in the grain boundary phase can facilitate control of the accumulated charge amount ratio Q100(600)/Q100(5) and the accumulated charge amount ratio Q200(600)/Q200(5) within a preferable range. The presence of the crystal compound in the grain boundary phase can be confirmed by XRD analysis. Determination as to whether the silicon nitride sintered body includes a crystal compound can be made based on the presence or absence of an XRD peak corresponding to the crystal compound.

The thermal conductivity of the silicon nitride sintered body is, for example, 65 W/m·K or more. If the thermal conductivity is less than 65 W/m·K, the heat dissipation of the silicon nitride sintered body is low. If the heat dissipation is low, the temperature of the silicon nitride substrate is likely to rise, and the substrate may be exposed to a high temperature. Since a rise in the temperature leads to an increase in the accumulated charge amount, it is desirable that the heat dissipation of the silicon nitride sintered body be high. The thermal conductivity can be improved by controlling the components of the grain boundary phase and their ratios. The thermal conductivity is preferably 65 W/m·K or more, and more preferably 100 W/m·K or more. The thermal conductivity is measured by a flash method conforming to JIS-R-1611 (2010). JIS-R-1611 corresponds to ISO 18755.

The three-point bending strength of the silicon nitride sintered body is preferably 600 MPa or more. As the strength is higher, the substrate can be made thinner. The three-point bending strength is measured in accordance with JIS-R-1601 (2008). JIS-R-1601 corresponds to ISO 14704.

The fracture toughness value of the silicon nitride sintered body is preferably 5.5 MPa·m^{1/2} or more, and more preferably 6.5 MPa·m^{1/2} or more. The fracture toughness is determined by performing measurement conforming to the IF method of JIS-R-1607 (2015) and using the Niihara's equation. JIS-R-1607 corresponds to ISO 15732.

The silicon nitride sintered body according to the embodiment can be used for a silicon nitride substrate. The thickness of the silicon nitride substrate is preferably within the range of not less than 0.1 mm and not more than 3 mm, and more preferably within the range of not less than 0.2 mm and not more than 1 mm. When the strength or the toughness of the silicon nitride substrate is improved in addition to the thermal conductivity of the silicon nitride substrate, the substrate can be made further thinner. This can allow the thickness of the silicon nitride substrate to be not less than 0.2 mm and not more than 0.4 mm.

In the embodiment, since the storage capacity ratio is controlled as described above, the insulation properties of the silicon nitride substrate is good. According to the embodiment, the dielectric strength of the silicon nitride substrate can be 15 kV/mm or more. The dielectric strength is measured by a two-terminal method conforming to JIS-C-2141 (1992). JIS-C-2141 corresponds to IEC 672-2.

According to the embodiment, the arc discharge voltage of the silicon nitride substrate can be 5 kV or more. The arc discharge voltage is measured by the following method. First, electrodes are disposed on the front face and the back face of the silicon nitride substrate 1 respectively. The silicon nitride substrate 1 is sandwiched between the pair of electrodes. In this state, an AC voltage of 50 Hz or 60 Hz is applied between the electrodes. The voltage rise rate is set to 200 V/s. A voltage when an arc discharge is detected between the electrodes is measured as an arc discharge voltage (kV). After the arc discharge voltage is measured, the application of the voltage is stopped without further increasing the voltage.

As the electrodes, for example, spherical electrodes specified in JIS-C-2110-1 (2013) are used. The diameter of the tip of the electrodes is 10 mm. JIS-C-2110-1 corresponds to IEC 60243-1. In the measurement environment, the temperature is controlled at 10°C to 25°C, and the humidity is controlled at 30% to 60%. The arc discharge voltage is measured in the atmosphere. Alternatively, the arc discharge voltage may be measured in an insulating oil, such as silicone oil, stable against an electric field.

The arc discharge voltage is measured at any three locations for one silicon nitride substrate 1, and the average value is recorded as the arc discharge voltage A (kV). Any three locations are selected so as not to overlap each other. The maximum voltage is set to 20 kV or less. The silicon nitride substrate 1 is put in a container so that the measurement is not affected by the air flow. As the measuring device, it is preferable to use the AC withstand voltage tester-7473 from Keisoku Giken Co., Ltd. Alternatively, a device having an arc discharge detection function equivalent to or higher than that of the AC withstand voltage tester-7473 may be used. The unit of the arc discharge voltage may be "kV/mm" obtained by dividing the voltage by the thickness of the silicon nitride substrate.

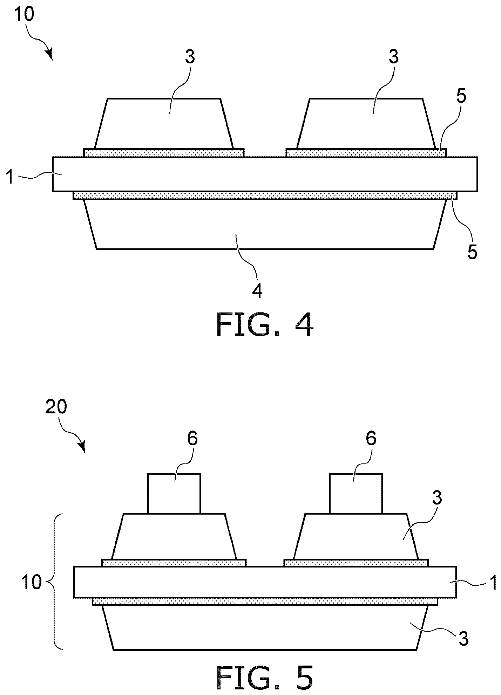

The silicon nitride substrate 1 can be used for a silicon nitride circuit board. FIG. 4 is a side view showing an example of a silicon nitride circuit board according to the embodiment. In FIG. 4, reference numeral 1 indicates the silicon nitride substrate, reference numeral 3 indicates a front metal plate, reference numeral 4 indicates a back metal plate, reference numeral 5 indicates a bonding layer, and reference numeral 10 indicates the silicon nitride circuit board. In the example shown in FIG. 4, the metal plates are bonded with the bonding layer 5 interposed. Here, the metal plate bonded to the front face of the silicon nitride substrate 1 is referred to as the front metal plate 3, and the metal plate bonded to the back face of the silicon nitride substrate is referred to as the back metal plate 4. Although FIG. 4 shows an example in which two front metal plates 3 are bonded, the number of front metal plates 3 may be one or three or more. Here, the front metal plate 3 and the back metal plate 4 are collectively referred to as a metal plate.

The metal plate is, for example, one or more types selected from the group consisting of a copper plate, a copper alloy plate, an aluminum plate, and an aluminum alloy plate. The metal plate is preferably a copper plate, and more preferably an oxygen-free copper plate. Oxygen-free copper has a copper purity of 99.96 wt% or more as indicated in JIS-H-3100 (2018). JIS-H-3100 corresponds to ISO 197, etc. The thermal conductivity of copper is about 400 W/m·K, and the thermal conductivity of aluminum is about 240 W/m·K. The thermal conductivity of copper is higher than the thermal conductivity of aluminum. Therefore, the use of a copper plate improves the heat dissipation of the metal plate. An aluminum plate is preferably composed of pure aluminum. Pure aluminum is indicated in JIS-H-4000 (2022). JIS-H-4000 corresponds to ISO 6361.

The thickness of the metal plate is preferably 0.3 mm or more. Increasing the thickness of the metal plate can improve the heat dissipation. The current carrying capacity can also be increased. Therefore, the thickness of the metal plate is preferably 0.3 mm or more, and more preferably 0.6 mm or more. The upper limit of the thickness of the metal plate is not specifically limited, but is preferably 5 mm or less. If the thickness exceeds 5 mm, control of the inclined shape of the side faces of the metal plate may become difficult. In particular, from the viewpoint of heat dissipation, it is preferable to use a copper plate having a thickness of 0.3 mm or more. It is preferable that both the thickness of the front copper plate and the thickness of the back copper plate be 0.3 mm or more.

The silicon nitride substrate 1 and the metal plate 3 are preferably bonded with the bonding layer interposed therebetween. The bonding layer is preferably formed by using an active metal bonding method. The active metal bonding method is a bonding method using one or more types of active metals selected from the group consisting of Ti (titanium), Zr (zirconium), and Hf (hafnium). In the active metal bonding method, an active metal brazing filler including an active metal is used. The main component of the active metal brazing filler is copper (Cu) or silver (Ag). The main component refers to a component whose content is largest among the metal components of the brazing filler.

The active metal brazing filler preferably contains Ag (silver) in an amount of not less than 0 mass% and not more than 70 mass%, Cu (copper) in an amount of not less than 15 mass% and not more than 85 mass%, and Ti (titanium) or TiH₂ (titanium hydride) in an amount of not less than 1 mass% and not more than 15 mass%. In a case where both Ti and TiH₂ are used, the total amount of Ti and TiH₂ is set within the range of not less than 1 mass% and not more than 15 mass%. In a case where both Ag and Cu are used, Ag is preferably within the range of not less than 20 mass% and not more than 60 mass%, and Cu is preferably within the range of not less than 15 mass% and not more than 40 mass%.

The active metal brazing filler may contain one or two types of Sn (tin) or In (indium) in an amount of not less than 1 mass% and not more than 50 mass%, if necessary. The content of Ti or TiH₂ is preferably within the range of not less than 1 mass% and not more than 15 mass%. The active metal brazing filler may contain C (carbon) in an amount of not less than 0.1 mass% and not more than 2 mass%, if necessary.

The ratio of the composition of the active metal brazing filler is calculated by assuming that the total of raw materials to be mixed is 100 mass%. For example, in a case where the active metal brazing filler is composed of three types of Ag, Cu, and Ti, the sum of the masses of Ag, Cu, and Ti is assumed to be 100 mass%. In a case where the active metal brazing filler is composed of four types of Ag, Cu, TiH₂, and In, the sum of the masses of Ag, Cu, TiH₂, and In is assumed to be 100 mass%. In a case where the active metal brazing filler is composed of five types of Ag, Cu, Ti, Sn, and C, the sum of the masses of Ag, Cu, Ti, Sn, and C is assumed to be 100 mass%.

Ag or Cu is a base material component of the brazing filler. Sn or In has an effect of lowering the melting point of the brazing filler. C (carbon) has an effect of controlling the fluidity of the brazing filler or an effect of controlling the composition of the bonding layer by reacting with other components. The components of the brazing filler are, for example, Ag-Cu-Ti, Ag-Cu-Sn-Ti, Ag-Cu-Ti-C, Ag-Cu-Sn-Ti-C, Ag-Ti, Cu-Ti, Ag-Sn-Ti, Cu-Sn-Ti, Ag-Ti-C, Cu-Ti-C, Ag-Sn-Ti-C, or Cu-Sn-Ti-C. In may be used instead of Sn. Both Sn and In may be used.

One or more types selected from the group consisting of tungsten (W), molybdenum (Mo), and rhenium (Re) may be added to the active metal brazing filler in an amount of not less than 0.1 mass% and not more than 10 mass%. When tungsten, molybdenum, or rhenium is added, the fluidity of the active metal brazing filler can be controlled. Magnesium (Mg) may be added to the active metal brazing filler.

The active metal brazing filler described above is effective in bonding a copper plate. In a case where the metal plate is a copper plate, it is preferable that the silicon nitride substrate and the copper plate be bonded with an Ag-free bonding layer interposed therebetween. "Ag-free" means that Ag is not added. As an unavoidable impurity, Ag of 0.01 mass% or less (including zero as "below the detection limit") may be included in the bonding layer. Using the Ag-free bonding layer can suppress the occurrence of Ag ion migration. Ag ion migration is a phenomenon in which Ag in the bonding layer is ionized and moves when a voltage is applied in a humid environment. When Ag ions move, they are deposited at another place. This causes insulation failure. Among the components of the active metal brazing filler, Ag is most likely to cause ion migration. Using no Ag in the bonding layer can suppress Ag ion migration.

In a case where the metal plate is an aluminum plate, the active metal brazing filler is preferably an Al-Si or Al-Mg brazing filler. In a case where the active metal brazing filler includes either Si or Mg, its content is preferably within the range of not less than 0.1 mass% and not more than 20 mass%. In a case where the active metal brazing filler includes both Si and Mg, the total content of Si and Mg is preferably within the range of not less than 0.1 mass% and not more than 20 mass%.

The metal plate may be subjected to etching processing, if necessary. For example, the metal plate is given a circuit shape by etching processing. A protruding portion of the bonding layer may be formed by etching processing. The protruding portion is a portion of the bonding layer protruding from the end portion of the metal plate.

Instead of the metal plate, a thin film or a metallized film may be used. The thin film is a conductive film formed by a sputtering method or a plating method. The metallized film is a conductive layer formed by applying and firing a metal powder paste.

The silicon nitride circuit board can be used for a semiconductor device in which a semiconductor element is mounted. FIG. 5 is a side view showing an example of a semiconductor device according to the embodiment. In FIG. 5, reference numeral 6 indicates a semiconductor element, reference numeral 10 indicates the silicon nitride circuit board, and reference numeral 20 indicates the semiconductor device.

In the example shown in FIG. 5, one semiconductor element 6 is mounted on each of the front metal plates 3. In the semiconductor device according to the embodiment, the number of mounted semiconductor elements may be one or more. The semiconductor element 6 may be mounted on the front metal plate 3 with, for example, a solder layer interposed therebetween, if necessary. For example, a lead frame, wire bonding, or a mold resin may be used, if necessary. In the example shown in FIG. 5, the back metal plate 4 is used as a heat sink. A semiconductor element may also be mounted on the back metal plate 4.

In the embodiment, the accumulated charge amount ratio at the driving voltage of the semiconductor element is controlled. Therefore, the silicon nitride substrate according to the embodiment has excellent long-term reliability. As described above, the driving voltage of the power card is designed to be around 1 kV. Generally, the driving voltage of power cards is designed to be within the range of not less than 0.6 kV and not more than 1.4 kV (a range rounded to 1 kV). The DC electric field of 5 kV/mm is a condition assuming the driving voltage of the semiconductor element. Therefore, the accumulated charge amount ratio is appropriate as an index indicating long-term reliability under practical conditions.

A method for manufacturing the silicon nitride sintered body according to the embodiment will now be described. The method for manufacturing the silicon nitride sintered body according to the embodiment is not specifically limited as long as the silicon nitride sintered body has the characteristics described above. Here, an example method for obtaining the silicon nitride sintered body with a high yield will be described. The example method for manufacturing the silicon nitride substrate will be described below.

First, a silicon nitride powder and a sintering aid powder, which are raw materials, are prepared. The silicon nitride powder is manufactured by, for example, an imide decomposition method or a direct nitridation method. The average particle diameter of the silicon nitride powder is preferably within the range of not less than 0.1 µm and not more than 4 µm.

As the sintering aid, one or more types selected from the group consisting of a rare earth element, titanium (Ti), hafnium (Hf), zirconium (Zr), magnesium (Mg), calcium (Ca), tungsten (W), and molybdenum (Mo) can be used. A compound of one or more types selected from the group may be used as the sintering aid. The compound is, for example, an oxide, a nitride, or an oxynitride.

The rare earth element is yttrium (Y) or a lanthanoid element. The lanthanoid element is, for example, ytterbium (Yb), erbium (Er), europium (Eu), lutetium (Lu), lanthanum (La), cerium (Ce), or dysprosium (Dy). The average particle diameter of the sintering aid powder is preferably within the range of not less than 0.1 µm and not more than 4 µm.

The silicon nitride powder and the sintering aid powder can include an impurity, such as fluorine, iron, or sodium. It is preferable that the amount of one or more types of impurities selected from the group consisting of fluorine, iron, and sodium be controlled.

The silicon nitride powder is manufactured by an imide decomposition method or a direct nitridation method. In the imide decomposition method, silicon halide is used as a raw material. In the direct nitridation method, a fluorine compound is used as a catalyst for nitriding metallic silicon. When the silicon nitride powder is manufactured, hydrofluoric acid washing is sometimes performed. Therefore, fluorine is likely to remain in the silicon nitride powder.

Iron is likely to be mixed during the manufacturing process of the silicon nitride powder or the manufacturing process of the sintering aid powder. Iron is also likely to be mixed during the manufacturing process of the silicon nitride substrate. This is because the component parts of the manufacturing equipment are often composed of an iron alloy. For example, if the inner wall of the manufacturing equipment is formed of an iron alloy, the silicon nitride powder may rub against the iron alloy, and iron may be mixed into the raw material powder.

As a neutralizing agent after the hydrofluoric acid washing, NaOH is sometimes used. Therefore, the neutralization salt of Na may remain and be mixed into the silicon nitride powder.

In order to control the content of each of fluorine, iron, and sodium in the silicon nitride substrate, it is effective to control the content of each of fluorine, iron, and sodium in the raw material powder. The sum total of the content of fluorine in the silicon nitride powder and the content of fluorine in the sintering aid powder is preferably not less than 0 wtppm and not more than 1000 wtppm. The sum total of the content of iron in the silicon nitride powder and the content of iron in the sintering aid powder is preferably not less than 0 wtppm and not more than 500 wtppm. The sum total of the content of sodium in the silicon nitride powder and the content of sodium in the sintering aid powder is preferably not less than 0 wtppm and not more than 500 wtppm.

In order to control the content of each of fluorine, iron, and sodium in the raw material powder, it is effective to use in advance a powder in which their contents are small. It is also effective to perform the following processing on the raw material powder. In order to reduce fluorine and sodium, it is preferable to perform a washing process with pure water in the process of manufacturing the raw material powder. It is also effective to perform the washing process a plurality of times. Further, in order to reduce iron, it is preferable to perform, for example, magnet removal or an electromagnetic deironing machine on the raw material powder.

After the silicon nitride powder and the sintering aid powder are mixed, a mixing process using a pulverizer is performed. This further mixes the raw material powder. The pulverizer is, for example, a ball mill or a bead mill. In the mixing process, for example, a binder and a solvent are added to the mixed powder to prepare a raw material powder slurry. The binder is, for example, an organic binder. The solvent is, for example, water or an organic solvent.

Next, a drying process is performed to dry a compact. In the drying process, a constant-rate drying period and a decreasing-rate drying period are calculated from the weight loss behavior of the solvent. It is preferable to set the temperature and the time in the constant-rate drying period and the decreasing-rate drying period. The constant-rate drying period is a period in which the solvent evaporates from a ceramic compact at an approximately constant rate. In the constant-rate drying period, the solvent in the vicinity of the surface of the ceramic compact evaporates. In the decreasing-rate drying period, the solvent inside the ceramic compact evaporates. The constant-rate drying period and the decreasing-rate drying period can be distinguished from each other based on a major location where the solvent evaporates. During the transition period from the constant-rate drying period to the decreasing-rate drying period, contraction stress applied to the compact becomes maximum. Therefore, controlling the constant-rate drying period and the decreasing-rate drying period leads to suppression of voids. Controlling voids leads to control of surface irregularities.

The weight loss rate of the solvent during the constant-rate drying period is preferably 0.2 mass%/min or more. The upper limit of the weight loss rate of the solvent during the constant-rate drying period is not specifically limited, but is preferably 10 mass%/min or less. When the weight loss rate exceeds 10 mass%/min, voids may become larger. Therefore, the weight loss rate of the solvent during the constant-rate drying period is preferably within the range of not less than 0.2 mass%/min and not more than 10 mass%/min.

The weight loss rate is calculated by the following method. First, the mass of the compact is measured before the drying process. Thereafter, the mass of the compact is measured every 2 to 5 minutes while the drying process is performed. Further, it is determined whether each timing is in the constant-rate drying period or in the decreasing-rate drying period, while a location where the solvent mainly evaporates is checked. The weight loss rate during each period is calculated from the mass before the drying process and the mass during the drying process. Alternatively, the drying process may be performed with the compact disposed on a mass measuring device. In this case, the weight loss rate is calculated by measuring the amount of change in the mass during the drying process.

The weight loss rate of the solvent during the decreasing-rate drying period is preferably smaller than the weight loss rate of the solvent during the constant-rate drying period. The ratio (R2/R1) of a weight loss rate R2 of the solvent during the constant-rate drying period to a weight loss rate R1 of the solvent during the decreasing-rate drying period preferably exceeds 1 and is not more than 20. During the constant-rate drying period, evaporation routes of the solvent are formed in the vicinity of the surface of the compact. When the ratio (R2/R1) is within the range of exceeding 1 and not more than 20, the solvent inside the ceramic compact can be evaporated through the evaporation routes during the decreasing-rate drying period. When the ratio (R2/R1) exceeds 20, the weight loss rate during the decreasing-rate drying period is excessively slow, and therefore, the possibility that the solvent inside the ceramic compact is unable to be sufficiently removed becomes high . The solvent remaining inside the ceramic compact can cause large voids. Further, if the weight loss rate during the decreasing-rate drying period is slow, the manufacturing efficiency decreases. The weight loss rate of the solvent during the decreasing-rate drying period is preferably not less than 0.01 mass%/min and less than 0.2 mass%/min.

The time of the drying process is determined in accordance with the amount of the solvent included in the compact. In an example, the ratio of the mass of the solvent to the mass of the mixed powder is about 0.1 to 0.6. In this case, the drying process is performed so that the weight after the drying process is not more than 0.6 times the weight before the drying process.

The compact subjected to the drying process is subjected to a degreasing process. The degreasing process is preferably performed within the range of not less than 400°C and not more than 800°C. With the degreasing process, an organic substance, such as the binder, is removed. The solvent remaining after the drying process can also be removed.

The degreased body is subjected to a sintering process. The sintering process is performed by heating the compact at a temperature of not less than 1650°C and not more than 1950°C for not less than 4 hours and not more than 24 hours in a non-oxidizing atmosphere. The non-oxidizing atmosphere is preferably a nitrogen gas atmosphere or a reducing atmosphere including a nitrogen gas. The pressure in the firing furnace is preferably a pressurized atmosphere.

In a case where the sintering temperature is less than 1650°C, a dense sintered body is less likely to be obtained. In contrast, in a case where the sintering temperature is higher than 1950°C, self-decomposition of Si₃N₄ is likely to occur, and a dense sintered body is less likely to be obtained. Therefore, it is preferable that the sintering temperature be controlled within the above-described range.

Preferably, a heat treatment process is performed in the process of temperature rise to the sintering temperature. In the heat treatment process, the degreased body is held at not less than 1400°C and less than 1650°C for not less than 1 hour and not more than 8 hours. A temperature of not less than 1400°C and less than 1650°C is a temperature zone in which the sintering aid reacts and changes to a liquid phase. The liquid phase diffuses so as to fill a gap between silicon nitride crystal particles. With the heat treatment process, diffusion of the liquid phase composed of the sintering aid is promoted and controlled, which leads to a decrease in voids in the sintered body.

The obtained silicon nitride substrate is subjected to surface treatment, if necessary. The surface treatment is performed so that the maximum height Sz becomes 60 µm or less. The surface treatment preferably includes a ductile mode. The surface treatment is, for example, lapping, buffing, or honing. The ductile mode is a mode in which the amount of grinding decreases in small amounts. In the ductile mode, shedding of, for example, polycrystalline ceramics is less likely to occur. The ductile mode is distinguished from a brittle mode in which the processing target is removed by a large amount. In the ductile mode, the surface after the treatment becomes clean, but the treatment time may be longer.

For example, in lapping, the silicon nitride substrate is sandwiched by a lapping machine using a liquid abrasive. With the lapping machine, the surface of the silicon nitride substrate is polished. In honing, abrasive grains are slanted against the surface of the silicon nitride substrate to polish the surface.

### (Examples)

### (Examples 1 to 6 and Comparative Example 1)

A silicon nitride powder and a sintering aid powder were prepared. The average particle diameter of each powder was 2 µm or less. The mixed powder of the silicon nitride powder and the sintering aid powder was subjected to a pulverizing process using a ball mill. The ratio of each mixed component is shown in Table 1. Each ratio was calculated by assuming that the sum total of the silicon nitride powder and the sintering aid powder was 100 mass%. The content of each of fluorine (F), iron (Fe), and sodium (Na) in the mixed powder was measured. The results are shown in Table 1.

**[Table 1]**

| | Mixture ratio (mass%) | Content (wtppm) | | |
|---|---|---|---|---|
| | | F | Na | Fe |
| Example 1 | Si₃N₄(89), Y₂O₃(4), Er₂O₃(4), MgO(1), TiO₂(1), HfO₂(1) | 60 | 50 | 90 |
| Example 2 | Si₃N₄(92), Y₂O₃(6), MgO(0.7), HfO₂(1.3) | 410 | 20 | 200 |
| Example 3 | Si₃N₄(93), Y₂O₃(5), MgO(2) | 80 | 110 | 150 |
| Example 4 | Si₃N₄(93), Er₂O₃(6), MgO(1) | 340 | 20 | 280 |
| Example 5 | Si₃N₄(88), Y₂O₃(5), Er₂O₃(4), MgO(1.5), TiO₂(1), HfO₂(0.5) | 460 | 40 | 230 |
| Example 6 | Si₃N₄(92.3), Y₂O₃(5.5), MgO(1.2), HfO₂(1) | 92 | 5 | 72 |
| Comparative example 1 | Si₃N₄(95), Y₂O₃(4), MgO(1) | 740 | 100 | 325 |

A binder and a solvent were added to the mixed raw material powder. The mixed raw material powder, the binder, and the solvent were mixed with the ball mill to thereby prepare a raw material powder slurry. The raw material powder slurry was used to form a sheet by the doctor blade method. The obtained long-length sheet compact was cut into a required size. Here, the sheet obtained by cutting the long-length sheet compact is called "sheet compact".

Next, the sheet compact was subjected to the drying process. In the drying process, the weight loss rate (wt%/min) of the solvent during the constant-rate drying period was measured. The ratio (R2/R1) of the weight loss rate R2 of the solvent during the constant-rate drying period to the weight loss rate R1 of the solvent during the decreasing-rate drying period was calculated. The results are shown in Table 2.

**[Table 2]**

| | Weight loss rate of solvent during constant-rate drying period (wt%/min) | Ratio R2/R1 of weight loss rate |
|---|---|---|
| Example 1 | 0.3 | 2 |
| Example 2 | 0.5 | 3 |
| Example 3 | 0.7 | 5 |
| Example 4 | 1.0 | 2 |
| Example 5 | 1.5 | 3 |
| Example 6 | 0.5 | 2 |
| Comparative example 1 | 4 | 25 |

The sheet compact subjected to the drying process was subjected to the degreasing process. The degreased body thus obtained was subjected to the sintering process. In the process of temperature rise, the degreased body was held in a non-oxidizing atmosphere at not less than 1400°C and less than 1650°C for not less than 1 hour and not more than 8 hours. Thereafter, the degreased body was held at not less than 1650°C and not more than 1950°C for not less than 4 hours and not more than 24 hours. With this process, a silicon nitride substrate (silicon nitride sintered body) was obtained.

Next, the silicon nitride substrate was subjected to surface treatment. The surface treatment was one of lapping, buffing, or honing.

With the above-described processes, the silicon nitride substrates according to Examples and Comparative Example were prepared. The size of the obtained silicon nitride substrates is 100 mm on the long side and 80 mm on the short side. All of the silicon nitride substrates had a thermal conductivity of 65 W/m·K or more, a three-point bending strength of 600 MPa or more, and a fracture toughness value of 5.5 MPa.m^{1/2} or more.

For the silicon nitride substrates according to Examples and Comparative Example, the content of each of fluorine, iron, and sodium was measured. The surface roughness and dielectric strength of each silicon nitride substrate were measured. As the surface roughness, the maximum height Sz, the maximum peak height Sp, and the maximum valley depth Sv were measured. The measurement methods were as described above. The results are shown in Table 3.

**[Table 3]**

| | Content of impurity (wtppm) | | | Surface roughness (µm) | | | Dielectric strength (kV) | Thickness (mm) |
|---|---|---|---|---|---|---|---|---|
| | F | Na | Fe | Sz | Sp | Sv | | |
| Example 1 | 40 | 20 | 150 | 39 | 20 | 19 | 9.7 | 0.32 |
| Example 2 | 200 | 10 | 200 | 21 | 14 | 7 | 9.9 | 0.32 |
| Example 3 | 50 | 50 | 270 | 36 | 18 | 18 | 8.7 | 0.25 |
| Example 4 | 180 | 10 | 350 | 44 | 21 | 23 | 8.5 | 0.25 |
| Example 5 | 220 | 20 | 310 | 52 | 25 | 27 | 9.6 | 0.32 |
| Example 6 | 72 | 0 | 47 | 38 | 19 | 19 | 9.9 | 0.32 |
| Comparative example 1 | 300 | 40 | 430 | 82 | 62 | 20 | 9.4 | 0.32 |

Next, the accumulated charge amount of each silicon nitride substrate was measured. The accumulated charge amount was measured with the Q(t) meter (model No. AD-9832A) from A&D Company, Limited, and a measurement electrode of 40 mmϕ was used. The size of the measurement electrode was selected so as not to cause creeping leakage of the silicon nitride substrate. The electrodes were disposed on the front and back sides of the silicon nitride substrate. A voltage corresponding to the thickness of the silicon nitride substrate was applied so that the applied voltage was 5 kV/mm. The accumulated charge amount was measured at room temperature (25°C), 100°C, and 200°C. The accumulated charge amount ratio was calculated from the obtained results. The results are shown in Tables 4 to 6. The unit of the accumulated charge amount is nC (nano Coulomb).

**[Table 4]**

| | Q25(5) | Q25(600) | Q25(600)/Q25(5) |
|---|---|---|---|
| Example 1 | 410 | 445 | 1.085 |
| Example 2 | 405 | 655 | 1.617 |
| Example 3 | 415 | 505 | 1.217 |
| Example 4 | 405 | 625 | 1.543 |
| Example 5 | 420 | 785 | 1.869 |
| Example 6 | 401 | 442 | 1.102 |
| Comparative example 1 | 405 | 1315 | 3.247 |

**[Table 5]**

| | Q100(5) | Q100(600) | Q100(600)/Q100(5) |
|---|---|---|---|
| Example 1 | 420 | 495 | 1.179 |
| Example 2 | 410 | 815 | 1.988 |
| Example 3 | 420 | 555 | 1.321 |
| Example 4 | 410 | 795 | 1.939 |
| Example 5 | 430 | 860 | 2.000 |
| Example 6 | 403 | 478 | 1.186 |
| Comparative example 1 | 415 | 2120 | 5.108 |

**[Table 6]**

| | Q200(5) | Q200(600) | Q200(600)/Q200(5) |
|---|---|---|---|
| Example 1 | 430 | 530 | 1.233 |
| Example 2 | 420 | 955 | 2.274 |
| Example 3 | 425 | 615 | 1.447 |
| Example 4 | 415 | 855 | 2.060 |
| Example 5 | 435 | 1065 | 2.448 |
| Example 6 | 408 | 580 | 1.421 |
| Comparative example 1 | 420 | 3035 | 7.226 |

As can be seen from Tables 4 to 6, in Examples, the accumulated charge amount ratios were improved as compared with Comparative Example 1. The silicon nitride substrates according to Examples exhibited excellent performance at all of 25°C, 100°C, and 200°C. Accordingly, it was found that the silicon nitride substrates according to Examples can be used as a silicon nitride circuit board having excellent long-term reliability even in a case where a semiconductor element having a high heat generation temperature is mounted. In contrast, in Comparative Example 1, although the accumulated charge amount ratio Q100(600)/Q100(5) and the accumulated charge amount ratio Q200(600)/Q200(5) were within the preferable ranges, the accumulated charge amount ratio Q25(600)/Q25(5) exceeded 3.0.

Further, the arc discharge voltage of each silicon nitride substrate was measured. The arc discharge voltage of each silicon nitride substrate was 5 kV or more. In contrast, the arc discharge voltage in Comparative Example 1 was less than 5 kV.

Embodiments of the invention include the following features.

### (Feature 1)

A silicon nitride sintered body,
in a case where a DC electric field of 5 kV/mm is applied to the silicon nitride sintered body at 25°C,
a ratio Q25(600)/Q25(5) of not less than 1.0 and not more than 3.0, the ratio Q25(600)/Q25(5) being a ratio of an accumulated charge amount 600 seconds after a start of application to an accumulated charge amount 5 seconds after the start of the application, and
a thermal conductivity of 65 W/m·K or more.

### (Feature 2)

The silicon nitride sintered body according to feature 1, in which a content of fluorine is not less than 0 wtppm and not more than 1000 wtppm.

### (Feature 3)

The silicon nitride sintered body according to feature 1 or 2, in which a content of iron is not less than 0 wtppm and not more than 500 wtppm.

### (Feature 4)

The silicon nitride sintered body according to any one of features 1 to 3, in which a content of sodium is not less than 0 wtppm and not more than 500 wtppm.

### (Feature 5)

The silicon nitride sintered body according to any one of features 1 to 4, in which the silicon nitride sintered body has a surface having a maximum height Sz of 60 µm or less.

### (Feature 6)

The silicon nitride sintered body according to any one of features 1 to 5, in which in a case where a DC electric field of 5 kV/mm is applied to the silicon nitride sintered body at 100°C, a ratio Q100(600)/Q100(5) of an accumulated charge amount 600 seconds after a start of application to an accumulated charge amount 5 seconds after the start of the application is not less than 1.0 and not more than 5.0.

### (Feature 7)

The silicon nitride sintered body according to any one of features 1 to 6, in which in a case where a DC electric field of 5 kV/mm is applied to the silicon nitride sintered body at 200°C, a ratio Q200(600)/Q200(5) of an accumulated charge amount 600 seconds after a start of application to an accumulated charge amount 5 seconds after the start of the application is not less than 1.0 and not more than 10.0.

### (Feature 8)

A silicon nitride substrate including:
the silicon nitride sintered body according to any one of features 1 to 7,
the silicon nitride substrate having a thickness of not less than 0.2 mm and not more than 1 mm.

### (Feature 9)

A silicon nitride circuit board including:
the silicon nitride substrate according to feature 8; and
a metal plate bonded to the silicon nitride substrate.

### (Feature 10)

A semiconductor device including:
the silicon nitride circuit board according to feature 9; and
a semiconductor element mounted on the metal plate.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention. Further, the above-described embodiments can be implemented in combination with each other.

### [Reference Numeral List]

1 silicon nitride substrate (silicon nitride sintered body)
2 surface portion
3 front metal plate
4 back metal plate
5 bonding layer
6 semiconductor element
10 silicon nitride circuit board
20 semiconductor device

## Claims

1. A silicon nitride sintered body,
in a case where a DC electric field of 5 kV/mm is applied to the silicon nitride sintered body at 25°C,
a ratio Q25(600)/Q25(5) of not less than 1.0 and not more than 3.0, the ratio Q25(600)/Q25(5) being a ratio of an accumulated charge amount 600 seconds after a start of application to an accumulated charge amount 5 seconds after the start of the application, and
a thermal conductivity of 65 W/m·K or more.

2. The silicon nitride sintered body according to claim 1, wherein a content of fluorine is not less than 0 wtppm and not more than 1000 wtppm.

3. The silicon nitride sintered body according to claim 1, wherein a content of iron is not less than 0 wtppm and not more than 500 wtppm.

4. The silicon nitride sintered body according to claim 1, wherein a content of sodium is not less than 0 wtppm and not more than 500 wtppm.

5. The silicon nitride sintered body according to claim 1, wherein
a content of fluorine is not less than 0 wtppm and not more than 1000 wtppm,
a content of iron is not less than 0 wtppm and not more than 500 wtppm, and
a content of sodium is not less than 0 wtppm and not more than 500 wtppm.

6. The silicon nitride sintered body according to claim 1, wherein the silicon nitride sintered body has a surface having a maximum height Sz of 60 µm or less.

7. The silicon nitride sintered body according to claim 5, wherein the silicon nitride sintered body has a surface having a maximum height Sz of 60 µm or less.

8. The silicon nitride sintered body according to claim 1, wherein in a case where a DC electric field of 5 kV/mm is applied to the silicon nitride sintered body at 100°C, a ratio Q100(600)/Q100(5) of an accumulated charge amount 600 seconds after a start of application to an accumulated charge amount 5 seconds after the start of the application is not less than 1.0 and not more than 5.0.

9. The silicon nitride sintered body according to claim 1, wherein in a case where a DC electric field of 5 kV/mm is applied to the silicon nitride sintered body at 200°C, a ratio Q200(600)/Q200(5) of an accumulated charge amount 600 seconds after a start of application to an accumulated charge amount 5 seconds after the start of the application is not less than 1.0 and not more than 10.0.

10. The silicon nitride sintered body according to claim 7, wherein in a case where a DC electric field of 5 kV/mm is applied to the silicon nitride sintered body at 100°C, a ratio Q100(600)/Q100(5) of an accumulated charge amount 600 seconds after a start of application to an accumulated charge amount 5 seconds after the start of the application is not less than 1.0 and not more than 5.0.

11. The silicon nitride sintered body according to claim 10, wherein in a case where a DC electric field of 5 kV/mm is applied to the silicon nitride sintered body at 200°C, a ratio Q200(600)/Q200(5) of an accumulated charge amount 600 seconds after a start of application to an accumulated charge amount 5 seconds after the start of the application is not less than 1.0 and not more than 10.0.

12. A silicon nitride substrate comprising:
the silicon nitride sintered body according to any one of claims 1 to 11,
the silicon nitride substrate having a thickness of not less than 0.2 mm and not more than 1 mm.

13. A silicon nitride circuit board comprising:
the silicon nitride substrate according to claim 12; and
a metal plate bonded to the silicon nitride substrate.

14. A semiconductor device comprising:
the silicon nitride circuit board according to claim 13; and
a semiconductor element mounted on the metal plate.
